(19) Europäisches Patentamt / European Patent Office / Office européen des brevets

(11) **EP 3 252 478 A1**

(12) **EUROPEAN PATENT APPLICATION**
published in accordance with Art. 153(4) EPC

(43) Date of publication:
06.12.2017 Bulletin 2017/49

(21) Application number: 16743057.8

(22) Date of filing: 08.01.2016

(51) Int Cl.:
*G01P 15/08* (2006.01)          *B81B 3/00* (2006.01)
*G01C 19/5747* (2012.01)       *G01C 19/5769* (2012.01)
*G01P 15/125* (2006.01)        *G01P 15/18* (2013.01)
*H01L 29/84* (2006.01)

(86) International application number:
PCT/JP2016/050424

(87) International publication number:
WO 2016/121453 (04.08.2016 Gazette 2016/31)

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR
Designated Extension States:
BA ME
Designated Validation States:
MA MD

(30) Priority: 26.01.2015 JP 2015011946

(71) Applicant: Hitachi Automotive Systems, Ltd.
Hitachinaka-shi, Ibaraki 312-8503 (JP)

(72) Inventors:
• DEGAWA Munenori
  Hitachinaka-shi
  Ibaraki 312-8503 (JP)
• KIKUCHI Hiroshi
  Hitachinaka-shi
  Ibaraki 312-8503 (JP)
• OKAMOTO Akihiro
  Hitachinaka-shi
  Ibaraki 312-8503 (JP)
• YURA Masashi
  Hitachinaka-shi
  Ibaraki 312-8503 (JP)
• HAYASHI Masahide
  Hitachinaka-shi
  Ibaraki 312-8503 (JP)

(74) Representative: MERH-IP Matias Erny Reichl
Hoffmann
Patentanwälte PartG mbB
Paul-Heyse-Strasse 29
80336 München (DE)

(54) **SEMICONDUCTOR SENSOR DEVICE**

(57) The purpose of the present invention is to improve the pressure resistance of a cavity in a semiconductor sensor device employing a resin package, and to do so without adversely affecting the embeddability of an electrically conductive member. The semiconductor sensor device has a gap 1a sealed in an airtight manner inside a laminate structure of a plurality of laminated substrates 1, 4, and 5, and has a structure in which the outside of the laminate structure is covered by a resin, wherein a platy component 2 having at least one side that is greater in length than the length of one side of the gap 1a along this side is arranged to the outside of an upper wall 1b of the gap 1, the upper wall 1b of the gap being mechanically suspended by the platy component 2.

FIG. 2

EP 3 252 478 A1

**EP 3 252 478 A1**

**Description**

Technical Field

The present invention relates to a semiconductor sensor device and more specifically relates to a MEMS (Micro Electro Mechanical Systems) device into which structures are sealed in an airtight manner such as an inertial sensor such as an acceleration or angular velocity sensor measuring a motion state of a moving body such as a vehicle, an airplane, a robot, a mobile phone, and a video camera, and a vibrator for generating filters and clocks.

Background Art

In recent years, for the purpose of prevention of hand shake of a digital camera, posture control for an automobile and a robot, and the like, a sensor including a vibrator using a MEMS technique has widely been used.
In general, the vibrator of this kind is formed by processing a semiconductor substrate such as a silicon substrate with use of the MEMS technique such as etching and is sealed in an airtight manner by attaching another substrate to the semiconductor substrate under a preset atmosphere and pressure environment. For example, JP 5298047 B2 (PTL 1) describes an angular velocity sensor chip and an acceleration sensor chip sealed in an airtight manner.
Also, as a package structure for the sensor chip, a plastic package attracts attention. The plastic package has higher mass productivity than a conventional ceramic package and is an efficient package structure to decrease manufacturing cost of the sensor. For example, JP 10-148642 A (PTL 2) describes an acceleration sensor using a plastic package.

Citation List

Patent Literature

**[0005]**

　　PTL 1: JP 5298047 B2
　　PTL 1: JP 10-148642 A

Summary of Invention

Technical Problem

According to the aforementioned conventional technique, the vibrator in the sensor chip is sealed in an airtight manner in a cavity formed between the attached substrates. Also, the inside of the cavity is in an atmospheric pressure or vacuum state. In a case of plastic-packaging such a sensor chip by means of a transfer mold process, high pressure is applied to the sensor chip when plastic is filled in the mold with as high pressure as 5 to 20 MPa or so. At this time, since a pressure difference between the inside and the outside of the sensor chip increases, the cavity of the sensor chip is deformed. In a case in which stress that is equal to or higher than breaking stress of a material constituting the cavity is applied to the cavity, the cavity will break, and airtightness in the cavity will be lost. Also, in a case in which the entire cavity is depressed in a direction toward the vibrator, the vibrator may break together.
The relationship between stress σ and pressure P is expressed by Equation 1. To improve withstanding pressure of a cavity upper part, it is apparent that the substrate at the cavity upper part needs to be thickened. The maximum stress at this time is applied to an end portion of a cavity longer side, and the cavity breaks at the portion against the withstanding pressure.

$$h^2 = \alpha P a^2 / \sigma \qquad (\text{Equation 1})$$

In the equation, h is a thickness of the substrate at the cavity upper part, a is a length of a cavity shorter side, and α is a coefficient.
However, in a case in which an electric signal is to be input/output between the vibrator and an outside of the sensor chip, the electric connection with the outside of the sensor chip is sometimes established by means of wire bonding by forming a through interconnection in a vertical direction of a substrate forming the cavity and providing the cavity upper part with a pad for the wire bonding. At this time, to form the through interconnection, the substrate is etched

2

in the vertical direction, the etched sidewall is electrically isolated by an isolator, and a conductive member is buried. In a case in which the substrate at the cavity upper part is thickened to improve withstanding pressure of the cavity upper part, the burying performance of the conductive member will be degraded, and the airtightness will be degraded. Also, resistance Rv of the through interconnection expressed in Equation 2 will increase. Consequently, a thermal noise Vn expressed in Equation 3 will increase, and the sensor performance will be lowered. In consideration of these problems, it is not easy to thicken the substrate at the cavity upper part.

$$Rv = \rho t/A \qquad (Equation~2)$$

In the equation, t is a length of the through interconnection, A is a cross-sectional area of the through interconnection, and $\rho$ is resistivity of the conductive member.

$$Vn = \sqrt{(4kt(Rv + Rs)B)} \quad (Equation~3)$$

In the equation, k is a Boltzmann coefficient, B is a bandwidth of a signal, T is an absolute temperature, and Rs is interconnection resistance in a horizontal direction of the cavity substrate.

An object of the present invention is to improve withstanding pressure of a cavity without degrading burying performance of a conductive member in a semiconductor sensor device using a plastic package.

Solution to Problem

To solve the above problem, in a semiconductor sensor device according to the present invention, a suspension substrate is attached directly on a cavity substrate into a structure in which a cavity upper part is suspended by the suspension substrate. Thus, the thickness h of the cavity upper part expressed in Equation 1 appears to increase as much as the thickness of the suspension substrate. Also, a substrate at the cavity upper part does not need to be thickened, and a length of a through interconnection does not need to increase. As a result, withstanding pressure P of the cavity upper part can be improved.

Advantageous Effects of Invention

According to the present invention, by suspending a cavity upper part with use of a suspension substrate, withstanding pressure of the cavity can be improved without degrading burying performance of a conductive member.

Brief Description of Drawings

[FIG. 1] FIG. 1 is a plan view of an acceleration sensor chip according to a first embodiment of the present invention.
[FIG. 2] FIG. 2 is a cross-sectional view along II-II in FIG. 1.
[FIG. 3] FIG. 3 is a cross-sectional view along III-III in FIG. 1.
[FIG. 4] FIG. 4 is a plan view illustrating the IV-IV cross-section in FIG. 2.
[FIG. 5] FIG. 5 is a plan view illustrating the V-V cross-section in FIG. 2.
[FIG. 6] FIG. 6 is a cross-sectional view of a chip package of the acceleration sensor chip according to the first embodiment of the present invention.
[FIG. 7] FIG. 7 is a plan view of the acceleration sensor chip according to a second embodiment of the present invention.
[FIG. 8] FIG. 8 is a plan view of the acceleration sensor chip according to a third embodiment of the present invention.
[FIG. 9] FIG. 9 is a plan view of an angular velocity sensor chip according to a fourth embodiment of the present invention.
[FIG. 10] FIG. 10 is a cross-sectional view along X-X in FIG. 9.
[FIG. 11] FIG. 11 is a cross-sectional view along XI-XI in FIG. 9.
[FIG. 12] FIG. 12 is a plan view illustrating the XII-XII cross-section in FIG. 10.
[FIG. 13] FIG. 13 is a plan view illustrating the XIII-XIII cross-section in FIG. 10.
[FIG. 14] FIG. 14 is a plan view of the acceleration sensor chip according to a fifth embodiment of the present invention.

Description of Embodiments

In the following embodiments, description will be provided by dividing the content into plural sections or embodiments as needed for convenience. However, these are not irrelevant to each other but have a relationship in which one is partially or entirely a modification example, a detail, a supplemental explanation, or the like of another unless otherwise stated.

Also, in the following embodiments, in a case in which the number (such as number, value, amount, and range) or the like of elements is stated, the number is not limited to the specified number but may be equal to, more than, or less than the specified number unless otherwise stated and unless it is apparent that the number is limited to the specified number in principle.

Further, in the following embodiments, it is to be understood that components (including component steps) thereof are not necessarily essential unless otherwise stated and unless it is apparent that the components are essential in principle.

Similarly, in the following embodiments, in a case in which a shape, a positional relationship, and the like of components are stated, the shape and the like shall include those approximate or similar to these unless otherwise stated and unless the shape and the like do not seem to include those approximate or similar to these in principle. The same is true of the aforementioned number and range.

Also, in the figures for describing the embodiments, similar components are shown with the same reference numerals, and description of the duplicate components is omitted. Also, to facilitate understanding of the figures, even a plan view may be hatched.

First Embodiment

In the present embodiment, the present invention will be described using a MEMS-type acceleration sensor. In particular, an example of using a capacitive sensing acceleration sensor as the MEMS-type acceleration sensor will be described.

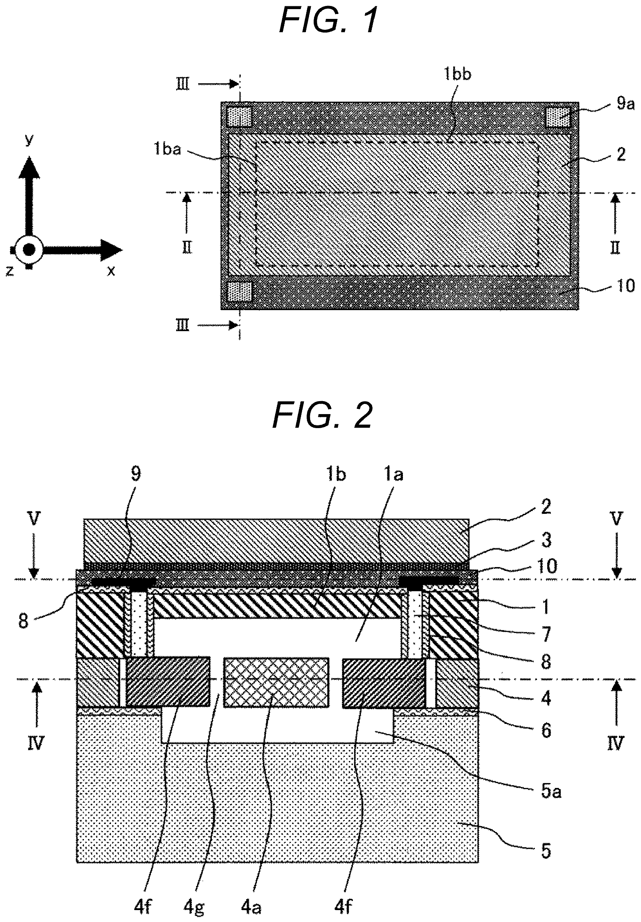

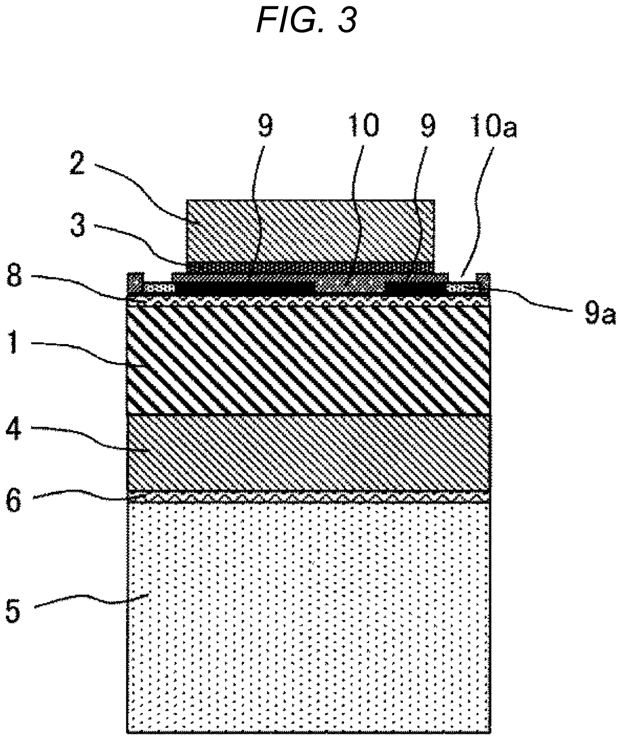

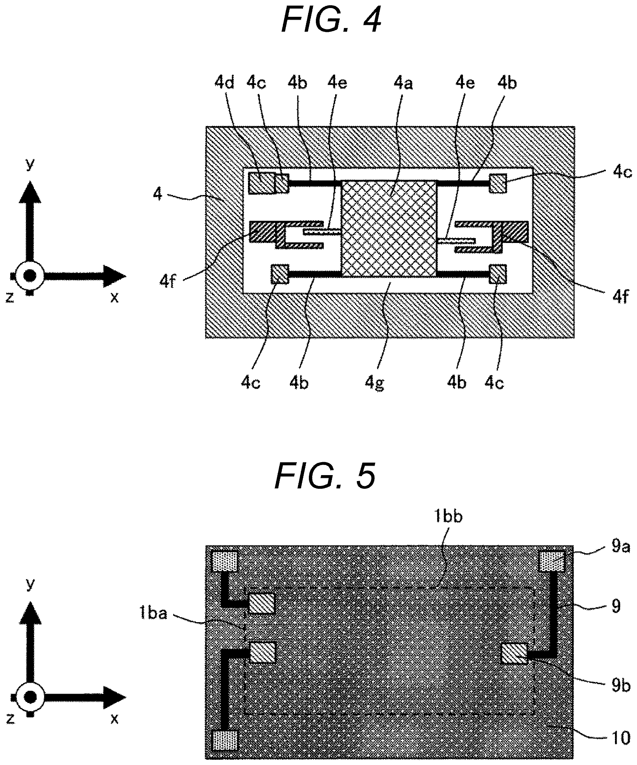

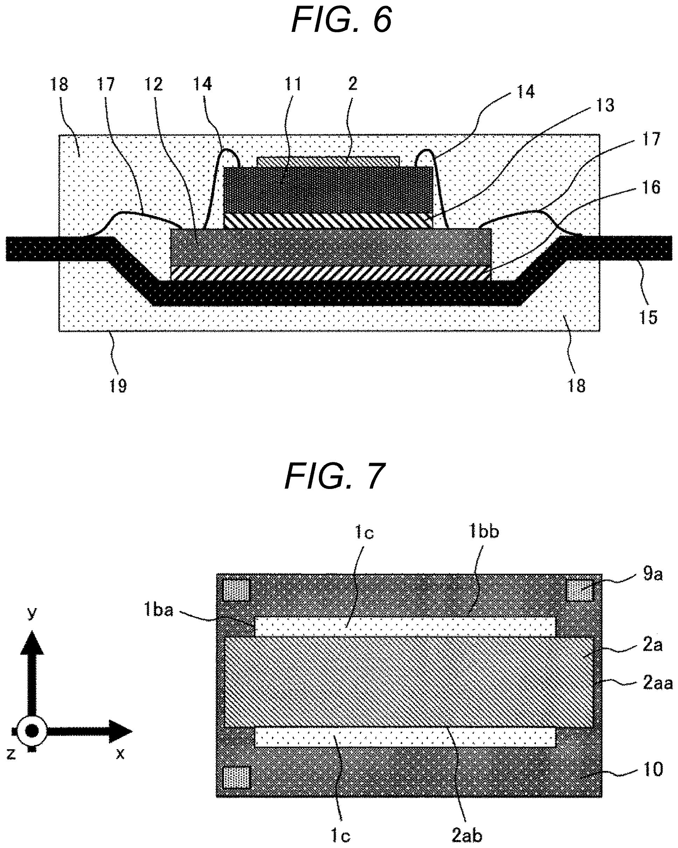

FIG. 1 is a plan view (upper view) of an acceleration sensor chip according to a first embodiment of the present invention. FIG. 2 is a cross-sectional view along II-II in FIG. 1. FIG. 3 is a cross-sectional view along III-III in FIG. 1. FIG. 4 is a plan view illustrating the IV-IV cross-section in FIG. 2. FIG. 5 is a plan view illustrating the V-V cross-section in FIG. 2. FIG. 6 is a cross-sectional view of a chip package 19 of an acceleration sensor chip 11 according to the first embodiment of the present invention.

The acceleration sensor according to the present embodiment includes a cavity substrate 1 forming a cavity 1a therein, a device substrate 4 forming a vibrator (weight) 4a therein, a support substrate 5 supporting the vibrator, and a suspension substrate 2 suspending a cavity upper part 1b of the cavity substrate 1.

In forming the vibrator, the device substrate 4 made of monocrystalline silicon and the support substrate 5 made of monocrystalline silicon or glass are first attached to each other via an insulating film 6. At this time, the support substrate 5 may or may not be provided with a cavity 5a in advance. Subsequently, the substrate assembly into which the device substrate 4 and the support substrate 5 are attached is subject to photolithography and DRIE (Deep Reactive Ion Etching) to process the device substrate 4 and the insulating film 6, to form the vibrator 4a.

As illustrated in FIG. 4, to the weight 4a, serving as the vibrator, formed on the device substrate 4, support beams 4b are connected in a direction perpendicular to a vibrating direction of the weight 4a. The other ends of these support beams 4b are respectively connected to anchors 4c provided in the direction perpendicular to the vibrating direction. At this time, since the anchors 4c are fixed to the support substrate 5 via the insulating film 6, the weight 4a can vibrate in a Y-axial direction. Also, some of the anchors 4c can electrically be connected to a below-mentioned through interconnection 7 similarly to an anchor 4d and are used to electrically connect the weight 4a to an external circuit.

Comb-like detection electrodes 4e formed on the device substrate 4 are formed outside the weight 4a. Comb-like fixed electrodes 4f are formed on the device substrate 4 and the insulating film 6 to face the comb-like detection electrodes 4e and are fixed to the support substrate 5. That is, the detection electrodes 4e are provided to project from an outer circumference of the weight 4a in an extending direction of the support beams 4b. Although only one detection electrode 4e is drawn in FIG. 4, the plurality of detection electrodes 4e are provided in a comb-like shape. Also, the fixed electrodes 4f receiving the comb-like detection electrodes 4e are provided in a comb-like shape to correspond to the number of the detection electrodes 4e.

As expressed in Equation 4, capacitance C is derived by a distance d between the detection electrode 4e and the fixed electrode 4f, a facing area A, dielectric constant $\varepsilon$, and a facing number n between the electrodes 4e and 4f.

$$C = \varepsilon An/d \qquad \text{(Equation 4)}$$

When acceleration is applied to the vibrator in the y direction, the weight 4a serving as a movable body is displaced in the y direction, and a displacement amount Δy between the electrodes at this time is a capacitance change ΔC.

Next, the cavity substrate 1 will be described. The cavity substrate 1 is made of monocrystalline silicon and is provided with a plurality of through holes for the cavity and the through interconnection 7 with use of photolithography and DRIE. The through interconnection 7 is formed by covering a sidewall of the through hole with an insulating film 8 and burying low-resistance silicon or a metal material therein. On an opposite surface of the surface provided with the cavity 1a, a planar interconnection 9 is formed as illustrated in FIG. 5. The planar interconnection 9 electrically connects a pad 9a arranged further outside than an outer circumference of the cavity 1a to the through interconnection 7 and is covered with an insulating film 10 except a pad opening portion 10a for protection against corrosion caused by damage and moisture.

By attaching the cavity substrate 1 configured as above to the device substrate 4, the detection electrode 4e and the fixed electrode 4f formed on the device substrate are electrically connected to the pad 9a on the upper surface of the cavity substrate 1 via the through interconnection 7 and the planar interconnection 9. At the time of attachment, the substrates are sealed in an airtight manner in atmospheric pressure or in a vacuum to obtain an effect of damping.

Subsequently, the suspension substrate 2 is mounted on the cavity upper part (cavity upper wall) 1b of the cavity substrate 1. At this time, the suspension substrate 2 is provided to cover a range from a position directly on the cavity 1a to an outside of an outer circumference of the cavity upper part 1b (1ba, 1bb). At this time, the suspension substrate 2 is provided to cover an upper side of the through interconnection 7 as illustrated in FIG. 2. Also, the thickness of the suspension substrate 2 is set so that withstanding pressure of the cavity upper part 1b may be higher than pressure at the time of below-mentioned plastic sealing as expressed in Equation 1 shown above. In mounting the suspension substrate 2, the suspension substrate 2 is attached via adhesive 3 such as DAF (Die Attach Film), epoxy, and silicon since a material for the suspension substrate 2 is assumed to be silicon or glass in FIGS. 2 and 3. In a case in which the material for the suspension substrate 2 is plastic, the plastic itself functions as adhesive, and the adhesive 3 can be dispensed with. In other words, the suspension substrate 2 is connected to the cavity substrate 1 by the adhesive or the plastic. Meanwhile, as described above, the insulating films 8 and 10 or the like are provided between the suspension substrate 2 and the cavity substrate 1 as needed.

The acceleration sensor chip 11 configured as above is assembled into the chip package 19 as illustrated in FIG. 6. The acceleration sensor chip 11 is implemented on a circuit board 12 via adhesive 13 and is electrically connected to the circuit board 13 by wire bonding 14. The circuit board 13 is implemented on a lead frame 15 via adhesive 16 and is electrically connected to the lead frame 15 by wire bonding 17. These are then sealed in plastic 18 into the chip package 19. At this time, the plastic 18 seals the entirety of the acceleration sensor chip 11 to cover the upper part of the suspension substrate 2 as illustrated in FIG. 6. In the plastic packaging by means of a transfer mold process, the sensor chip 11 is under a high-pressure environment as described above. However, since the cavity upper part 1b is suspended by the suspension substrate 2, withstanding pressure of the cavity upper part is higher than pressure at the time of the plastic sealing, and breakage of the cavity can be prevented.

A semiconductor sensor device according to the present embodiment includes the airtight cavity 1a in a laminated structure into which the plurality of substrates 1, 4, and 5 are laminated and has a structure in which an outside of the laminated structure is covered with the plastic 18. At an outside of the upper wall 1b of the cavity 1a is arranged the suspension substrate (plate-like member) 2 in which a length of at least one side thereof is longer than a length of a side of the cavity 1a residing along the side, and the plate-like member 2 mechanically suspends the upper wall 1b of the cavity 1a.

In the plate-like member 2, an opposite surface thereof of a surface thereof suspending the cavity upper wall 1b is covered with the plastic 18. Higher pressure than atmospheric pressure is applied to an outside of a part suspended by the plate-like member 2 on a surface suspended by the plate-like member 2.

In the present embodiment, the substrate (cavity substrate) 1 suspended by the plate-like member 2 includes the through electrode 7 provided at the part suspended by the plate-like member 2 and passing through the substrate 1 in a thickness direction, the pad 9a for wire bonding provided outside the part suspended by the plate-like member 2, and the interconnection (planar interconnection) 9 electrically connected to the through electrode 7, extracted outside the part suspended by the plate-like member 2, and electrically connected to the pad 9a. The planar interconnection 9 is made of metal or silicon.

In the present embodiment, the through interconnection 7 is provided to pass through the cavity substrate 1, and the suspension substrate 2 is provided to cover an upper side of the through interconnection 7. Thus, the through length of the through interconnection 7 will not be long, which can prevent burying performance of a conductive member for the through interconnection 7 from being degraded. The through interconnection 7 is electrically connected to the pad 9a arranged outside the suspension substrate 2 by the planar interconnection 9.

Second Embodiment

Next, a modification example of FIG. 1 will be described with reference to FIG. 7. FIG. 7 is a plan view of the acceleration sensor chip 11 according to a second embodiment of the present invention. It is to be noted that detailed description of similar components to those in FIG. 1 will be omitted, and different points will mainly be described below.

In the present embodiment, in a suspension substrate 2a suspending the cavity upper part 1b illustrated in FIG. 7, a length of a shorter side 2aa of the suspension substrate 2a is a length generating in the cavity substrate upper part 1b an area 1c not suspended by the suspension substrate 2a. That is, in the present embodiment, the cavity 1a is formed in a rectangular shape in which one side (two opposed sides) is a longer side while a side perpendicular to this longer side is a shorter side. Also, the suspension substrate (plate-like member) 2 is formed in a rectangular shape in which one side (two opposed sides) is a longer side while a side perpendicular to this longer side is a shorter side. The length of the shorter side of the suspension substrate 2 is a length that is shorter than the shorter side of the cavity and that causes a part of the cavity in the shorter-side direction not to be suspended. Meanwhile, although two areas 1c in the cavity substrate upper part 1b not suspended by the suspension substrate 2a are provided in FIG. 7, one area 1c may be provided on either side of the suspension substrate 2a.

Accordingly, as expressed in Equation 1 shown above, the length a of the shorter side 1ba of the cavity upper part 1b decreases, which brings about an effect of an increase in the withstanding pressure P of the cavity upper part. Also, since the longer side 1bb in the cavity upper part 1b of the cavity substrate 1, to which the maximum stress is applied, is included in the area 1c, one can easily determine whether or not the cavity upper part 1b breaks against the withstanding pressure by observing the area 1c.

In the present embodiment, the through interconnection 7 may be arranged in the area 1c not suspended by the suspension substrate 2. In this case, the through interconnection 7 can be configured not to be covered with the suspension substrate 2.

Third Embodiment

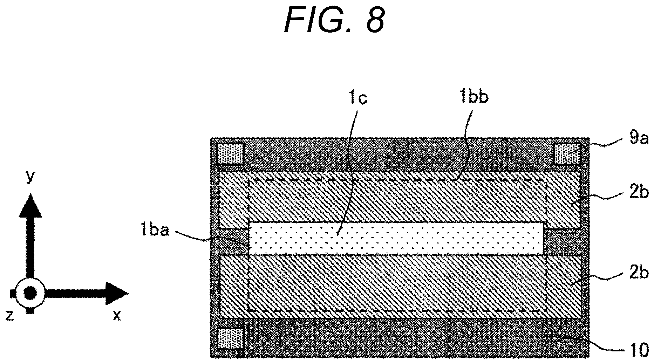

Next, a modification example of FIG. 1 will be described with reference to FIG. 8. FIG. 8 is a plan view of the acceleration sensor chip 11 according to a third embodiment of the present invention. It is to be noted that detailed description of similar components to those in FIG. 1 will be omitted, and different points will mainly be described below.

In the present embodiment, a plurality of suspension substrates 2c suspending the cavity upper part 1b are provided as illustrated in FIG. 8. Meanwhile, although the number of the suspension substrates 2c illustrated in FIG. 4 is two, the number may be two or more. Also, although one area 1c in the cavity upper part 1b not suspended by the suspension substrate 2c is provided in FIG. 8, two or more areas 1c may be provided.

Accordingly, as expressed in Equation 1 shown above, the length a of the shorter side 1ba of the cavity upper part 1b decreases, which brings about an effect of an increase in the withstanding pressure P of the cavity upper part.

In the present embodiment, the through interconnection 7 may be arranged in the area 1c not suspended by the suspension substrate 2. In this case, the through interconnection 7 can be configured not to be covered with the suspension substrate 2.

Fourth Embodiment

Hereinbelow, a MEMS-type angular velocity sensor will be described as a fourth embodiment of the present invention. In particular, an example of using a capacitive sensing angular velocity sensor as the MEMS-type angular velocity sensor will be described.

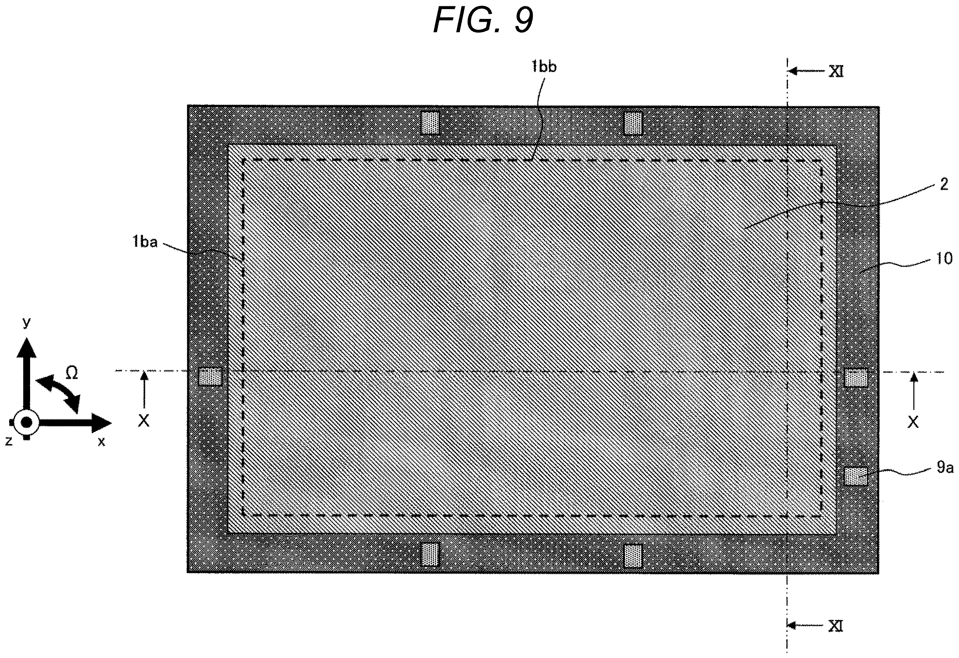

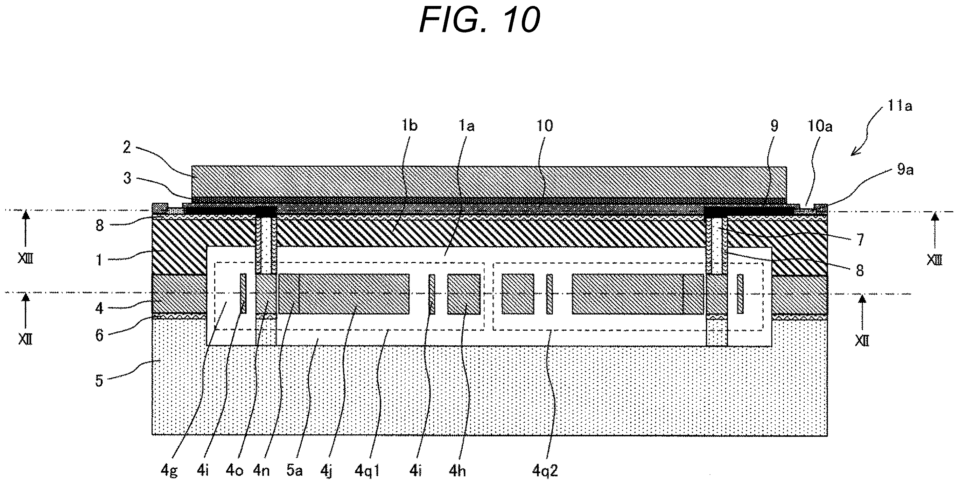

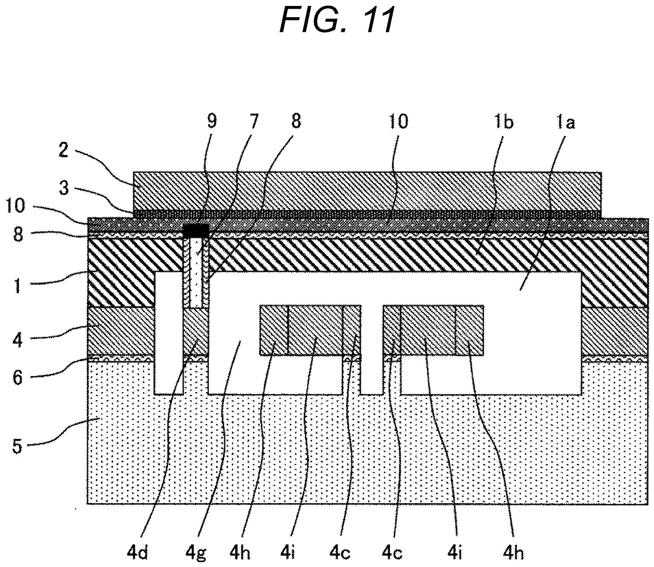

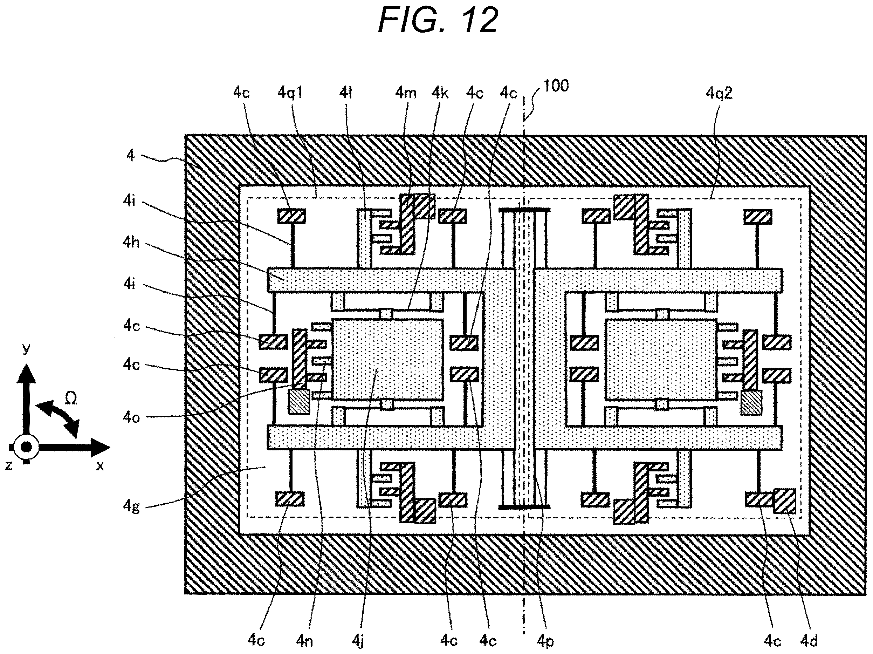

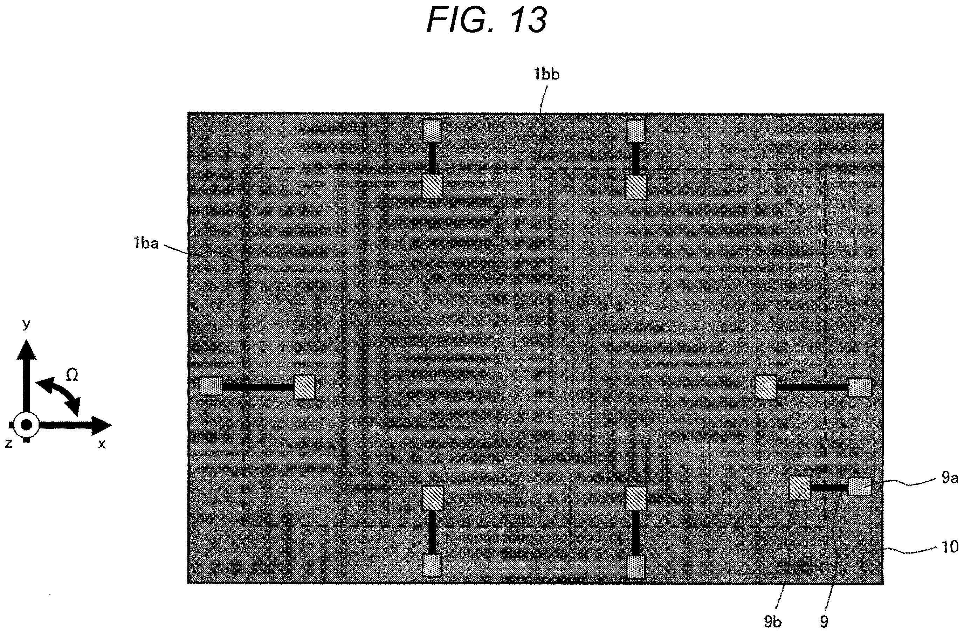

FIG. 9 is a plan view (upper view) of an angular velocity sensor chip 11a according to the fourth embodiment of the present invention. FIG. 10 is a cross-sectional view along X-X in FIG. 9. FIG. 11 is a cross-sectional view along XI-XI in FIG. 9. FIG. 12 is a plan view illustrating the XII-XII cross-section in FIG. 10. FIG. 13 is a plan view illustrating the XIII-XIII cross-section in FIG. 10.

The present structure can be prepared by a similar method to that of the structure illustrated in FIGS. 1, 2, 3, 4, 5, and 6 but differs in a structure of a vibrator prepared in the device substrate 4. In describing FIGS. 9, 10, 11, 12, and 13 below, detailed description of similar components to those in FIGS. 1, 2, 3, 4, 5, and 6 will be omitted, and different points will mainly be described.

In the present embodiment, the angular velocity sensor chip 11a has a configuration in which the cavity substrate 1 and the support substrate 5 are attached to the device substrate 4 forming a below-mentioned vibrator therein and are sealed in an airtight manner in a vacuum or in atmospheric pressure, and in which the cavity substrate upper part 1b is suspended by the suspension substrate 2.

Meanwhile, in the suspension substrate 2, as described in the second embodiment, the length of the shorter side 2aa of the suspension substrate 2a may be a length generating in the cavity substrate upper part 1b the area 1c not suspended by the suspension substrate 2a. Also, as described in the third embodiment, the plurality of suspension substrates 2 may be provided.

The angular velocity sensor chip 11a is assembled into the chip package 19 in a similar manner to FIG. 6.

In the angular velocity sensor chip 11a, a left-side vibrating unit 4q1 and a right-side vibrating unit 4q2 are arranged to be symmetrical and opposed to each other and are connected via a link beam 4p. That is, the vibrating unit 4q1 and the vibrating unit 4q2 are line-symmetrical across a center line 100 as illustrated in FIG. 12. As for a part formed only by the device substrate 4, both of the vibrating units are movable with respect to the support substrate 5 via the anchors 4c and the insulating film 6, and the vibrating units 4q1 and 4q2 are designed to have equal natural vibration frequency.

On the device substrate 4, a weight 4h, serving as a first vibrator, is formed, and to the weight 4h, support beams 4i are connected in a direction perpendicular to a driving direction of the vibrator. The other ends of these support beams 4i are respectively connected to the anchors 4c provided in the direction perpendicular to the driving direction. The weight 4h serving as the first vibrator can vibrate in an X-axial direction due to the support beams 4i. Also, some of the anchors 4c can electrically be connected to the aforementioned through interconnection 7 similarly to the anchor 4d and are used to electrically connect the vibrator side to an external circuit.

Comb-like driving electrodes 41 formed in the device substrate 4 are formed outside the weight 4h serving as the first vibrator. Comb-like driving electrodes 4m are formed on the device substrate 4 and the insulating film 6 to face the comb-like driving electrodes 41 and are fixed to the support substrate 5.

The driving electrode 4m is electrically connected to the pad 9a via the through interconnection 8 and the planar interconnection 9 on the cavity substrate and is connected to an external oscillating circuit. When a predetermined frequency signal is applied to the driving electrode 4m, an electrostatic force is generated between the electrodes 41 and 4m, and the weight 4h serving as the first vibrator vibrates in the X-axial direction.

On the device substrate 4, a weight 4j, serving as a second vibrator, is formed inside the weight 4h serving as the first vibrator. On the upper and lower sides of the weight 4j, detection beams 4k extending in an equal direction to the vibrating direction of the weight 4h are provided. That is, one end of the beam 4k is connected to the weight 4j. The other end of the beam 4k is connected to the weight 4h serving as the first vibrator. The weight 4j serving as the second vibrator is movable against the support substrate 5 and can vibrate in association with the weight 4h serving as the first vibrator due to the support beams 4k and also vibrate in the Y-axial direction perpendicular to the X-axial direction.

As a means to detect displacement of the weight 4j serving as the second vibrator in the Y-axial direction, comb-like detection electrodes 4n are provided on the device substrate 4 to be adjacent to the weight 4j. Comb-like detections 4o are provided at positions facing the detection electrodes 4n. The detection electrodes 4o are formed on the device substrate 4 and the insulating film 6 and are fixed to the support substrate 5. The detection electrode 4o is electrically connected to the pad 9a via the through interconnection 8 and the planar interconnection 9 on the cavity substrate 1 and is connected to an external signal processing circuit.

When the weight 4j serving as the second vibrator is displaced in the Y-axial direction, capacitance between the electrodes 4n and 4o changes, and the electrode 4o outputs a signal corresponding to the capacitance.

By arbitrarily setting the mass of the weight 4h serving as the first vibrator and the weight 4j serving as the second vibrator and the shapes of the support beams 4i, the weight 4h and the weight 4j vibrate in the X-axial direction with natural vibration frequency of fx.

Also, by arbitrarily setting the mass of the weight 4j serving as the second vibrator and the shapes of the detection beams 4k, the weight 4j vibrates in the Y-axial direction as well with natural vibration frequency of fy.

The angular velocity sensor according to the present embodiment is operated in the following manner.

First, alternating voltage with frequency of f is applied to the driving electrode 4m in FIG. 12 so that the left-side vibrating unit 4q1 and the right-side vibrating unit 4q2 may vibrate in opposite phase to cause an electrostatic force to be generated between the electrodes 4m and 4l and cause the weight 4h serving as the first vibrator to vibrate in the X-axial direction. At this time, the weight 4j serving as the second vibrator vibrates in the X-axial direction in association with the weight 4h. At this time, the relationship between displacement x of the weight 4h in the X-axial direction and speed v thereof is expressed by Equation 5.

$$x = Xe\sin(2\pi ft)$$

$$v = 2\pi f Xe\cos(2\pi ft) \qquad \text{(Equation 5)}$$

In Equation 5, f is frequency, Xe is amplitude, and t is time.

When angular velocity Ω is applied to the angular velocity sensor in a direction of an axis (Z) perpendicular to the drawing sheet of FIG. 12 in a state in which the weight 4h and the weight 4j vibrate in the X-axial direction, a Coriolis force Fc (Equation 6) is generated in the Y-axial direction. The weight 4j is displaced in the Y-axial direction by the Coriolis force Fc.

$$Fc = 2m\Omega v \qquad \text{(Equation 6)}$$

In Equation 6, m is mass of the weight 4j.

The weight 4j serving as the second vibrator vibrates in the Y-axial direction by the Coriolis force Fc expressed in Equation 6, and capacitance between the detection electrodes 4n and 4o changes. By detecting the capacitance change, the angular velocity $\Omega$ around the Z axis can be detected.

Meanwhile, as a method for measuring the displacement amount of the weight 4j serving as the second vibrator, voltage to be applied between the electrodes 4n and 4o may be servo-controlled so that the capacitance change between the detection electrodes 4n and 4o, that is, the displacement amount of the weight 4j in the Y-axial direction, may be zero, and the Coriolis force Fc may be derived from the applied voltage.

Also, since the left-side vibrating unit 4q1 and the right-side vibrating unit 4q2 arranged to be symmetrical and opposed to each other are provided, both of the vibrating units vibrate in opposite phase. Accordingly, while external acceleration is cancelled, a detection signal of angular velocity can be detected with high sensitivity as the sum of the two vibrating units. As another advantage, leakage of vibration of the vibrating units to an outside can be restricted.

Further, the present invention can be applied to a MEMS device having a cavity as well as the acceleration sensor and the angular velocity sensor. By suspending a cavity upper part by means of a suspension substrate, an effect of improvement in withstanding pressure of the cavity upper part can be obtained without thickening the cavity substrate.

Fifth Embodiment

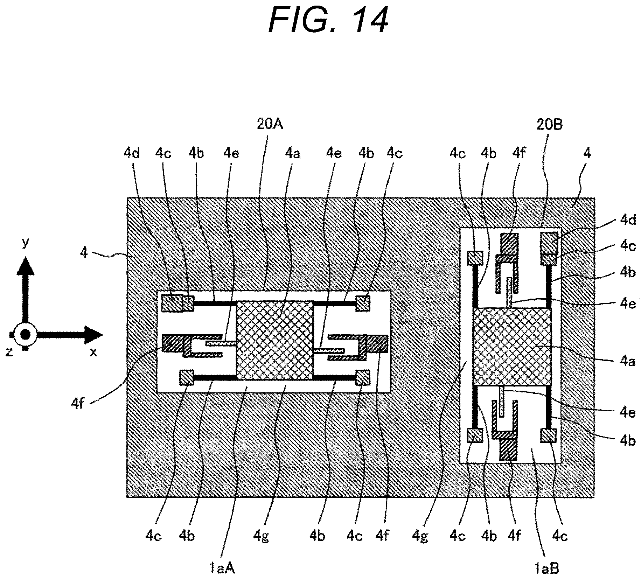

Hereinbelow, a fifth embodiment of the present invention will be described with reference to FIG. 14. FIG. 14 is a plan view of the acceleration sensor chip according to the fifth embodiment of the present invention. In the present embodiment, an example of using a capacitive sensing acceleration sensor as a MEMS-type acceleration sensor will be described. However, a capacitive sensing angular velocity sensor or another sensor may be used as the MEMS-type sensor.

In the present embodiment, a first acceleration sensor 20A detecting acceleration in the y direction and a second acceleration sensor 20B detecting acceleration in the x direction are provided. To include the first acceleration sensor 20A and the second acceleration sensor 20B in one sensor chip 11, two cavities 1aA and 1aB are provided in one sensor chip 11. The number of sensors included in the sensor chip 11 is not limited to one or two, and more sensors can be included. Also, the number of sensor kinds is not limited to one, and plural kinds of sensors may be combined. In this manner, by providing a plurality of cavities in accordance with the number of sensors included in the sensor chip 11, the function of the sensor chip 11 can be enhanced.

Effects obtained by the aforementioned respective embodiments are summarized in the following manner.

In the semiconductor sensor device including the cavity substrate, the configuration in which the cavity upper part of the cavity substrate is provided with the wider suspension substrate than the outer circumference of the cavity upper part, and in which the cavity upper part is thus suspended, provides the following effect. As described in Equation 1 shown above, the withstanding pressure P of the cavity upper part is a function for the thickness h of the cavity upper part and the stress $\sigma$. At this time, since the cavity upper part is thicker due to the suspension substrate, the withstanding pressure P is improved. At this time, by making the suspension substrate larger than the outer circumference of the cavity, an increase of the stress $\sigma$ to the end of the cavity upper part can be restricted by the suspension substrate, and the withstanding pressure P of the cavity upper part can be improved. Accordingly, by using such a configuration, a structure in which the withstanding pressure of the cavity upper part is improved can be achieved without thickening the cavity substrate itself.

Also, the configuration in which the length of the shorter side of the suspension substrate is a length that is shorter than the shorter side of the cavity upper part and that generates in a part of the cavity upper part the area not suspended by the suspension substrate provides the following effect. That is, as described in Equation 1 shown above, the length a of the cavity shorter side is short, and the withstanding pressure P can be improved. Also, since the end portion on the cavity longer side, to which the maximum stress is applied, is exposed, one can observe the area and can easily determine whether or not the cavity breaks against the withstanding pressure.

Further, the configuration in which the plurality of suspension substrates are provided provides the following effect. That is, as described in Equation 1 shown above, the length a of the cavity shorter side is short, and the withstanding pressure P can be improved.

Reference Signs List

| | |
|---|---|
| 1 | cavity substrate |
| 1a | cavity |
| 1b | cavity upper part |
| 1ba | shorter side of cavity upper part |
| 1bb | longer side of cavity upper part |
| 1c | area of cavity upper part not suspended |
| 2 | suspension substrate |
| 2a | suspension substrate |
| 2aa | shorter side of suspension substrate 2a |
| 2ab | longer side of suspension substrate 2a |
| 2b | suspension substrate |
| 3 | adhesive |
| 4 | device substrate |
| 4a | weight |
| 4b | support beam |
| 4c | anchor |
| 4d | anchor (connected to through interconnection) |
| 4e | detection electrode |
| 4f | fixed electrode |
| 4g | cavity |
| 4h | weight (first vibrator) |
| 4i | support beam |
| 4j | weight (second vibrator) |
| 4k | beam (for detection) |
| 4l | driving electrode (side of weight 4h) |
| 4m | driving electrode (fixed to support substrate) |
| 4n | detection electrode (side of weight 4j) |
| 4o | detection electrode (fixed to support substrate) |
| 4p | link beam |
| 4q1 | vibrating unit |
| 4q2 | vibrating unit |
| 5 | support substrate |
| 5a | cavity |
| 6 | insulating film |
| 7 | through interconnection |
| 8 | insulating film |
| 9 | planar interconnection |
| 9a | pad |
| 9b | through interconnection upper part |
| 10 | insulating film |
| 10a | pad opening portion |
| 11 | acceleration sensor chip |
| 11a | angular velocity sensor chip |
| 12 | circuit board |
| 13 | adhesive |
| 14 | wire bonding |
| 15 | lead frame |
| 16 | adhesive |
| 17 | wire bonding |
| 18 | plastic |
| 19 | chip package |

# EP 3 252 478 A1

**Claims**

1. A semiconductor sensor device including an airtight cavity in a laminated structure into which a plurality of substrates are laminated and having a structure in which an outside of the laminated structure is covered with plastic, wherein a plate-like member, in which a length of at least one side thereof is longer than a length of a side of the cavity residing along the side, is arranged at an outside of an upper wall of the cavity, and the plate-like member mechanically suspends the upper wall of the cavity.

2. The semiconductor sensor device according to claim 1, wherein, in the plate-like member, an opposite surface thereof of a surface thereof suspending the upper wall of the cavity is covered with the plastic.

3. The semiconductor sensor device according to claim 2, wherein the cavity is formed in a rectangular shape in which the side is a longer side while a side perpendicular to this longer side is a shorter side, wherein the plate-like member is formed in a rectangular shape in which the side is a longer side while a side perpendicular to this longer side is a shorter side, and wherein a length of the shorter side of the plate-like member is a length that is shorter than the shorter side of the cavity and that causes a part of the cavity in a shorter-side direction not to be suspended.

4. The semiconductor sensor device according to claim 2, wherein the plurality of plate-like members are provided.

5. The semiconductor sensor device according to claim 2, wherein the substrate suspended by the plate-like member includes a through electrode provided at a part suspended by the plate-like member and passing through the substrate in a thickness direction, a pad for wire bonding provided outside the part suspended by the plate-like member, and an interconnection electrically connected to the through electrode, extracted outside the part suspended by the plate-like member, electrically connected to the pad, and made of metal or silicon.

6. The semiconductor sensor device according to claim 2, wherein the plurality of cavities are provided in the laminated structure including the plurality of substrates.

7. The semiconductor sensor device according to claim 2, wherein a material for the plate-like member is a semiconductor, glass, or plastic.

8. The semiconductor sensor device according to claim 2, wherein the plate-like member mechanically suspends the cavity upper part via adhesive.

9. The semiconductor sensor device according to claim 2, wherein a material for the substrate is a semiconductor or glass.

10. The semiconductor sensor device according to claim 2, wherein higher pressure than atmospheric pressure is applied to a surface suspended by the plate-like member.

## FIG. 1

## FIG. 2

FIG. 3

## FIG. 4

4d 4c 4b 4e 4a 4e 4b

4

4f

4c 4b 4g 4b 4c

4c

4f

y

z x

## FIG. 5

1bb

9a

1ba

9

9b

10

y

z x

# FIG. 6

# FIG. 7

# FIG. 8

*FIG. 9*

EP 3 252 478 A1

# FIG. 10

# FIG. 11

# FIG. 12

# FIG. 13

# FIG. 14

## INTERNATIONAL SEARCH REPORT

International application No.

PCT/JP2016/050424

| A. CLASSIFICATION OF SUBJECT MATTER |
|---|
| G01P15/08(2006.01)i, B81B3/00(2006.01)i, G01C19/5747(2012.01)i, G01C19/5769(2012.01)i, G01P15/125(2006.01)i, G01P15/18(2013.01)i, H01L29/84(2006.01)i |
| According to International Patent Classification (IPC) or to both national classification and IPC |

| B. FIELDS SEARCHED |
|---|
| Minimum documentation searched (classification system followed by classification symbols) |
| G01P15/00-15/18, B81B3/00, G01C19/56-19/5783, H01L29/84 |

Documentation searched other than minimum documentation to the extent that such documents are included in the fields searched

| Jitsuyo Shinan Koho | 1922–1996 | Jitsuyo Shinan Toroku Koho | 1996–2016 |
| Kokai Jitsuyo Shinan Koho | 1971–2016 | Toroku Jitsuyo Shinan Koho | 1994–2016 |

Electronic data base consulted during the international search (name of data base and, where practicable, search terms used)

## C. DOCUMENTS CONSIDERED TO BE RELEVANT

| Category* | Citation of document, with indication, where appropriate, of the relevant passages | Relevant to claim No. |
|---|---|---|
| Y<br>A | JP 10-148642 A (Mitsubishi Electric Corp.),<br>02 June 1998 (02.06.1998),<br>paragraphs [0016] to [0030]; fig. 1 to 6<br>& DE 19727214 A1 & US 5864062 A<br>column 3, line 55 to column 6, line 47; fig. 1<br>to 6 | 1-2,4,6-10<br>3,5 |
| Y<br>A | WO 2014/021079 A1 (Murata Mfg. Co., Ltd.),<br>06 February 2014 (06.02.2014),<br>paragraphs [0013] to [0047]; fig. 1 to 2<br>& CN 104145426 A & JP 5565544 B<br>& KR 10-2014-0112511 A & US 2014/0339956 A1<br>paragraphs [0023] to [0047]; fig. 1 to 2 | 1-2,4,6-10<br>3,5 |

| ☒ Further documents are listed in the continuation of Box C. | ☐ See patent family annex. |
|---|---|

| * | Special categories of cited documents: |
|---|---|
| "A" | document defining the general state of the art which is not considered to be of particular relevance |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| | |
|---|---|
| "T" | later document published after the international filing date or priority date and not in conflict with the application but cited to understand the principle or theory underlying the invention |
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| 18 April 2016 (18.04.16) | 26 April 2016 (26.04.16) |

| Name and mailing address of the ISA/<br>Japan Patent Office<br>3-4-3,Kasumigaseki,Chiyoda-ku,<br>Tokyo 100-8915,Japan | Authorized officer<br><br>Telephone No. |
|---|---|

Form PCT/ISA/210 (second sheet) (January 2015)

**INTERNATIONAL SEARCH REPORT**

International application No.

PCT/JP2016/050424

C (Continuation). DOCUMENTS CONSIDERED TO BE RELEVANT

| Category* | Citation of document, with indication, where appropriate, of the relevant passages | Relevant to claim No. |
|---|---|---|
| A | JP 2014-99781 A (Nihon Dempa Kogyo Co., Ltd.), 29 May 2014 (29.05.2014), entire text; all drawings & CN 103824932 A & TW 201419596 A & US 2014/0132368 A1 | 1-10 |
| A | JP 2011-179821 A (Hitachi Automotive Systems, Ltd.), 15 September 2011 (15.09.2011), entire text; all drawings & EP 2362182 A2 & US 2011/0209815 A1 | 1-10 |
| A | US 2011/0193231 A1 (OPTOPAC CO., LTD.), 11 August 2011 (11.08.2011), entire text; all drawings & CN 102148262 A & KR 10-0976812 B1 | 1-10 |
| A | WO 2009/057699 A1 (Kyocera Corp.), 07 May 2009 (07.05.2009), entire text; all drawings & CN 101803189 A & JP 2013-48489 A & JP 2014-64329 A & JP 2014-99928 A & JP 2014-239516 A & US 2010/0225202 A1 | 1-10 |

Form PCT/ISA/210 (continuation of second sheet) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 5298047 B

- JP 10148642 A